# EUROPEAN PATENT SPECIFICATION

(11) **EP 0 780 730 B1**
(45) Date of publication and mention of the grant of the patent: **21.08.2002**
(21) Application number: 96120207.4
(22) Date of filing: 16.12.1996
(51) Int. Cl.: G03F 7/022, G03F 7/09

(54) **Positive-type light-sensitive lithographic printing plate**
Positiv arbeitende lichtempfindliche Druckplatte
Plaque d' impression photosensible de type positif

(30) Priority: 22.12.1995 JP 33514595
(43) Date of publication of application: 25.06.1997
(73) Proprietor: FUJI PHOTO FILM CO., LTD., Kanagawa-ken (JP)
(72) Inventor: Maemoto, Kazuo, Yoshida-cho, Haibara-Gun, Shizuoka (JP); Kawabe, Yasumasa, Yoshida-cho, Haibara-Gun, Shizuoka (JP)
(74) Representative: Grünecker, Kinkeldey, Stockmair & Schwanhäusser Anwaltssozietät

(56) References cited:
- WO-A-90/13058
- GB-A- 2 167 876
- US-A- 4 160 671
- US-A- 4 544 627
- US-A- 5 328 806
- US-A- 5 460 917

## Description

The present invention relates to a positive-type light-sensitive lithographic printing plate. More particularly, the present invention relates to a positive-type light-sensitive lithographic printing plate which is difficult to form unnecessary images of edge portions of a film in similarly reproducing the minimum dots, has a high sensitivity, and shows a good image visibility after image-exposure, a good suitability for plate inspection after development, and a good easiness to see resister marks as compared with conventional positive-type light-sensitive lithographic printing plates.

When a positive-type light-sensitive Lithographic printing plate prepared by forming a layer of a positive-working light-sensitive resin composition (hereinafter, the layer is sometimes referred to as a "light-sensitive layer") on an aluminum plate which was previously subjected to surface graining and an anodization treatment (hereinafter, the positive-type light-sensitive lithographic printing plate is referred to as "positive-type PS plate") is light-exposed through a positive transparent original, the solubility of the exposed portions for a developer is increased, and when the exposed positive-type PS plate is treated with a developer for a positive-working light-sensitive resin composition, the exposed portions of the light-sensitive layer are removed to expose a hydrophilic surface of the aluminum support, whereby a positive image is formed. In this case, when the light-exposure amount is reduced for reproducing the minimum dots, the light is scattered at the edge portions of a film, whereby the amount of light at the edge portions becomes deficient, unnecessary images at the edge portions are formed on a printing plate, and thus, after development, it becomes necessary to erase the unnecessary images formed on the printing plate. Thus, recently, lithographic printing plates having more faithful dot reproducing property have been desired.

For solving the above problem, a positive-type PS plate using an aluminum support having a surface of the dark, steel-grey tone obtained by graining the surface of an aluminum support with a wet abrasive such as pumice and then immediately anodizing the grained surface in a sulfuric acid solution is proposed in U.S. Patent 3,891,516. However, since the surface of the aluminum support of the positive-type PS plate has a low reflectance over the whole range of from the ultraviolet region to the visible light region, there are drawbacks that the printing-out image obtained at an image exposure becomes hard to see as well as the contrast between the sensitive images formed after development and the surface of the support is low, which results in making the so-called suitability for plate inspection poor, and thus the correcting works such as erasing, retouching, etc., are hindered.

In the system of using a yellow dye as described in JP-B-7-43533 (the term "JP-B" as used herein means an "examined published Japanese patent application"), the unnecessary images of the edge portions of a film are difficult to form on a PS printing plate, but a problem occurs that when the yellow dyes described in the JP-B are used, the sensitivity of the PS printing plate is greatly lowered.

As the method of solving the problem, there is a method of adding, in particular, a yellow azo dye in azo dyes as disclosed in JP-A-2-226250, JP-A-4-316049, JP-A-59-142538, and JP-A-58-87553 (the term "JP-A" as used herein means an "unexamined published Japanese patent application"). However, in these systems, the contrast between the image areas and non-image areas after light exposure is poor due to coloring of the azo dye.

US 5,460,917 describes a positive working photosensitive lithographic printing plate including a photosensitive composition which comprises a mixture of (a) a specific phenol derivative, (b) a water-soluble and aqueous alkali-soluble resin, and (c) o-quinonediazide or a mixture of a compound capable of forming an acid on exposure and a compound having at least one C-O-C group.

US 5,328,806 describes positive working radiation sensitive mixtures containing an admixture in a solvent of: an alkali soluble binder resin, a photoactive compound and an effective sensitivity enhancing amount of at least one dimeric or trimeric unit formed by the condensation reaction of an aldehyde with sesamol; the amount of said binder resin being about 60 to 95% by weight, the amount of said photoactive component being about 5% to about 40% by weight, based on the total solids content of said radiation-sensitive composition.

GB-A-2167876 describes a positive working presensitized plate which is obtained by colouring the surface of a grained and then anodised aluminum alloy plate with an ultraviolet light absorbing dye and then coating the coloured surface with a positive working light-sensitive composition.

Also, for a light-sensitive lithographic printing plate, a plate inspection is practiced for confirming the presence or absence of unnecessary images or dust on the printing plate after development. In this case, since if the contrast (ΔD) between the image area and the non-image area is good, the plate inspection is easily practiced, a blue coloring agent is generally used for giving a good contrast between the image area and the non-image area. In this case, for obtaining a sufficient suitability for plate inspection, it may be considered to increase the blue density. However, if a sufficient contrast is given, the yellow ratio of o-naphthoquinonediazide is relatively lowered, whereby the image areas become bluish and a greenish tone is reduced.

This causes the following problem. That is, since fitting of the position of a film to the position of a lithographic printing plate is carried out using register marks written on the lithographic printing plate with a yellow ball pen for fitting the positions under a yellow lamp, when the image area becomes from a greenish tone to a bluish tone, the problem occurs that the register marks become very difficult to see.

Furthermore, the plate inspection, which is carried out after development, is frequently seen by a white lamp, but when the image area becomes a bluish tone, the plate inspection becomes hard to see as compared to the case that the image area is greenish.

Accordingly, an object of the present invention is to provide a positive-type light-sensitive lithographic printing plate wherein in a dot reproduction similar to conventional cases, the unnecessary images of the edge portions of a film are difficult to form on the positive-type light-sensitive lithographic printing plate as compared with conventional positive-type light-sensitive lithographic printing plates, the image visibility after light exposure and the suitability for plate inspection after development are good, and it is easy to see the register marks of the lithographic printing plate, and which has a high sensitivity.

This object is achieved by a positive-type light-sensitive lithographic printing plate comprising an aluminium plate, which was grained and then subjected to an anodizing treatment, having formed on the surface thereof a layer of a light-sensitive composition containing following components a) to e):
a) an o-naphthoquinonediazide compound selected from 1,2 naphthoquinone-2-diazido-5-sulfonoyl halide and 1,2-naphthoquinone-2-diazido-4-sulfonyl halide, each being condensed with a polyhydroxyphenyl compound,
b) an alkaline water-soluble and water-insoluble resin,
c) a compound which generates an acid by light, selected fromo-naphthoquinonediazido-4-sulfonic acid halogenide,trihalomethyl-2-pyrone, trihalomethyltriazine and 2-trihalomethyl-5-aryl-1,3,4-oxadiazole,
d) a blue dye the tone of which is changed with an acid, and
e) a yellow dye represented by the following formula [I], [II] or [III], the absorbance at 417 nm of which is at least 70% of the absorbance of 436 nm 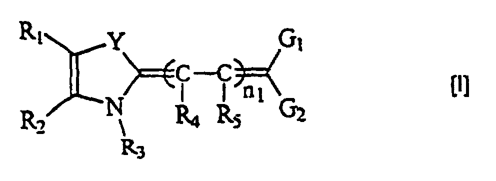
wherein R₁ and R₂ each independently represent a hydrogen atom, an alkyl group having from 1 to 10 carbon atoms, an aryl group, or an alkenyl group, and R₁ and R₂ may form a ring; R₃, R₄, and R₅ each independently represent a hydrogen atom or an alkyl group having from 1 to 10 carbon atoms; G₁ and G₂ each independently represent an alkoxycarbonyl group, an aryloxycarbonyl group, an acyl group, an arylcarbonyl group, an alkylthio group, an arylthio group, an alkylsulfonyl group, an arylsulfonyl group, or a fluoroalkylsulfonyl group, and G₁ and G₂ may form a ring; at least one of R₁, R₂, R₃, R₄, R₅, G₁, and G₂ has at least one of a sulfonic acid group, a carboxyl group, a sulfonamide group, an imido group, an N-sulfonylamide group, a phenolic hydroxyl group, a sulfonimide group, and the metal salts, the inorganic and organic ammonium salts of them; Y represents a divalent atom or atomic group selected from O, S, NR (wherein R represents a hydrogen atom, an alkyl group, or an aryl group), Se, -C(CH₃)₂-, and -CH=CH-; and n₁ represents 0 or 1; 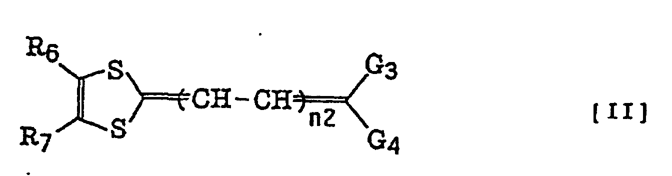 wherein R₆ and R₇ each independently represent a hydrogen atom, an alkyl group, a substituted alkyl group, an aryl group, a substituted aryl group, a heterocyclic group, a substituted heterocyclic group, an allyl group, or a substituted allyl group, and R₆ and R₇ may form a ring together with the carbon atoms to which R₆ and R₇ are bonded, respectively; n, represents 0, 1, or 2; G₃ and G₄, which may be the same or different, each represent a hydrogen atom, a cyano group, an alkoxycarbonyl group, a substituted alkoxycarbonyl group, an aryloxycarbonyl group, a substituted aryloxycarbonyl group, an acyl group, a substituted acyl group, an arylcarbonyl group, a substituted arylcarbonyl group, an alkylthio group, an arylthio group, an alkylsulfonyl group, an arylsulfonyl group, or a fluoroalkylsulfonyl group; with the proviso that G₃ and G₄ are not simultaneously a hydrogen atom, and also G₃ and G₄ may form a ring composed of non-metallic atoms together with the carbon atoms to which G₃ and G₄ are bonded, respectively; and at least one of R₆, R₇, G₃, and G₄ has at least one of a sulfonic acid group, a carboxyl group, a sulfonamide group, an imido group, an N-sulfonylamide group, a phenolic hydroxyl group, a sulfonimide group, and the metal salts, the inorganic and organic ammonium salts of them; 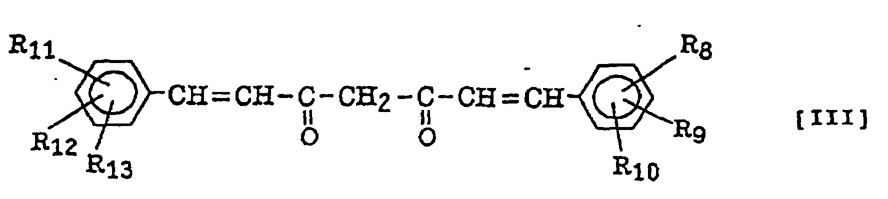 wherein R₈, R₉, R₁₀, R₁₁, R₁₂, and R₁₃, which may be the same or different, each represent a hydrogen atom, an alkyl group, a substituted alkyl group, an aryl group, a substituted aryl group, an alkoxy group, a hydroxyl group, an acyl group, a cyano group, an alkoxycarbonyl group, an aryloxycarbonyl group, a nitro group, a carboxyl group, a chlorine atom, or a bromine atom.

That is, in the positive-type light-sensitive lithographic printing plate of the present invention, the conventional problems described above are solved, the unnecessary images of the edge portions of a film are difficult to form on the plate, the image viability after light exposure and the suitability for plate inspection after development are good, the register marks of the plate are easy to see, and the light-sensitive lithographic printing plate has a high sensitivity.

In the specification of Japanese Patent Application No. 7-2143867, there is proposed a method of solving the problems on the suitability for plate inspection and the easiness of seeing the register marks. However, this method does not solve the problem of forming the unnecessary marks of the edge portions of a film on the a light-sensitive lithographic printing plate. Further, in this method, the contrast between the image areas and the non-image areas after light exposure becomes inferior.

As a result of various investigations, the inventors have found that since in the dyes described in the specification of Japanese Patent Application No. 7-214867 described above, the absorbances at 405 nm and 417 nm are very lower than the absorbance at 436 nm, matching thereof with the absorption of o-naphthoquinonediazide is poor, the problem on the formation of the unnecessary images of the edge portions of a film on the plate cannot be solved, and further the contrast between the image areas and the non-image areas after light exposure becomes bad.

That is, in the present invention, by using the yellow dye having a specific absorbance and a sensitive wavelength to a specific wavelength, matching with the light absorption of o-quinonediazide is improved, the problem on the formation of the unnecessary images of the edge portions of a film on the plate can be solved, and also the contrast between the image areas and the non-image areas after light exposure is improved.

Furthermore, in the present invention, by using a blue dye the tone of which is changed with an acid, not only the sufficient suitability for plate inspection after light exposure and development is obtained but also the image visibility after light exposure can be improved. Also, by adding the yellow dye e) described above, a blue tone becomes slightly greenish tone and thus the register marks become easy to see.

Moreover, by combining the yellow dye, the blue dye, and the compound generating an acid by light, which are used in this invention, the problems of the formation of the unnecessary images of the edge portions of a film, which is a conventional troublesome point, the reductions of the image visibility after image exposure and the suitability for plate inspection after development, the hardness of seeing register marks under a yellow lamp, lowering of the sensitivity, etc., can be all solved.

The present invention is described in detail below.

First, the positive-type light-sensitive printing plate of the present invention is explained.

The aluminum plate which can be used in the present invention as the support includes a pure aluminum plate and an aluminum alloy plate. Various aluminum alloys can be used as the aluminum alloy, and examples thereof are alloys of aluminum and one or more of metals such as silicon, copper, manganese, magnesium, chromium, zinc, lead, bismuth, nickel, etc. These alloys further contain negligible amounts of impurities in addition to iron and titanium.

Prior to graining the aluminum plate, if necessary, a rolling oil on the surface of the plate is removed and further a surface pre-treatment may be applied to the plate for revealing the clean aluminum surface. For the former, a solvent such as trichlene, etc., or an aqueous solution of a surface active agent, etc., is used. Also, for the latter, a method of using an aqueous solution of an alkali etching agent, such as sodium hydroxide, potassium hydroxide, etc., is widely used.

As a graining method which can be used in the present invention, any of a mechanical method, a chemical method, and an electrochemical method can be effectively used. The mechanical method includes a ball rubbing method, and a blast rubbing method, and a brush rubbing method of rubbing an aqueous dispersion slurry of an abrasive such as pumice to the surface of the aluminum plate with a nylon brush. As the chemical graining method, the method of immersing the aluminum plate in a saturated aqueous solution of the aluminum salt of a mineral acid as described in JP-A-55-31187 is suitable. Also, as the electrochemical method, a method of alternating current electrolyzing in an acidic electrolyte of hydrochloric acid, nitric acid, or a combination thereof is preferred. In these graining methods, the graining method by combining mechanical graining and electrochemical graining as described in JP-A-55-137993 is particularly preferable since the adhesive force of sensitive images to the support is strong.

The aluminum plate thus grained is, if necessary, washed with water and chemically etched.

The etching treatment liquid used in Lhe present invention is usually selected from an aqueous solution of a base and an aqueous solution of an acid each dissolving aluminum. In this case, a layer of a compound different from an aluminum compound induced from the component of the etching liquid must not be formed on the etched surface of the aluminum plate. Examples of the preferred etching agent are shown below. Examples of basic materials are sodium hydroxide, potassium hydroxide, trisodium phosphate, disodium phosphate, tripotassium phosphate, and dipotassium phosphate. Examples of acidic materials are sulfuric acid, persulfuric acid, phosphoric acid, hydrochloric acid, and the salts thereof. The salts of metals having a lower ionization tendency than aluminum, such as zinc, chromium, cobalt, nickel, or copper, are not preferred since these salts each form an unnecessary film or layer on the etched surface of the aluminum plate.

It is most preferred that in using the above etching agent, the concentration thereof and the temperature are such that the dissolution speed of aluminum or an aluminum alloy used is from 0.3 to 40 g/m² per one minute of the immersion time, but the dissolution rate may be higher or lower than the above range.

Etching of an aluminum plate is carried out by immersing the aluminum plate in the etching liquid or coating the etching liquid on the aluminum plate. In this case, it is preferred that the aluminum plate is subjected to the etching treatment such that the etched amount is in the range of from 0.1 to 10 g/m².

As the etching agent, an aqueous solution of the base is preferably used due to the feature of high etching speed. In this case, since smuts are formed, the etched aluminum plate is usually subjected to a desmutting treatment. Examples of the acid used for the desmutting treatment are nitric acid, sulfuric acid, phosphoric acid, chromic acid, hydrofluoric acid, and borofluoric acid.

An anodizing treatment is applied to the etched aluminum plate for increasing the water-holding property and the abrasion resistance of the aluminum plate. As an electrolyte used for the anodizing treatment of the aluminum plate, any electrolyte which forms a porous oxide film or layer can be used. Generally, sulfuric acid, phosphoric acid, oxalic acid, chromic acid, or a mixed acid thereof is used. The concentration of the electrolyte is properly decided according to the kind of the electrolyte used.

The conditions of the anodizing treatment cannot be indiscriminately specified since the conditions are variously changed according to the kind of the electrolyte used. However, in general, it is appropriate that the concentration of the electrolyte in the electrolyte solution is from 1 to 80% by weight, the temperature of the solution is from 5 to 70°C, the electric current density is from 1 to 60 A/dm², the voltage is from 1 to 100 volts, and the electrolytic time is from 10 seconds to 5 minutes.

The anodizing treatment in an aqueous sulfuric acid solution (sulfuric acid method) is usually carried using a direct electric current, but an alternating electric current can also be used. The concentration of sulfuric acid is from 5 to 30% by weight and the electrolytic treatment is carried out at a temperature range of from 20 to 60°C for from 5 to 250 seconds. In this case, it is preferred that the electrolytic solution contains an aluminum ion. Further, the current density in this case is preferably from 1 to 20 A/dm².

In the phosphoric acid method, the anodizing treatment is carried out for from 10 to 300 seconds at a phosphoric acid concentration of from 5 to 50% by weight, a temperature of from 30 to 60°C, and a current density of from 1 to 15 A/dm².

The amount of the anodic oxidation film (the anodized film) is suitably at least 1.0 g/m², and more preferably in the range of from 2.0 to 6.0 g/m². When the amount of the anodic oxidation film is less than 1.0 g/m², the printability is insufficient and the non-image areas of the lithographic printing plate is liable to be scratched, whereby a so-called "scratch strain" formed by attaching an ink to the scratched portions is liable to occur at printing.

After applying the anodizing treatment, the surface of the aluminum plate is, if necessary, subjected to a hydrophilic treatment. As the hydrophilic treatment used in the present invention, there is a method of using aqueous solution of an alkali metal silicate (for example, an aqueous solution of sodium silicate) as disclosed in U.S. Patents 2,714,066, 3,181,461, 3,280,734, and 3,902,734. In the method, the aluminum support is immersed in an aqueous solution of sodium silicate or is electrolyzed in the aqueous solution.

A method of treating an aqueous solution of potassium fluorozirconate disclosed in JP-B-36-22063 or a method of treating with vinylsulfonic acid as disclosed in U.S. Patents 3,276,868, 4,153,451, and 4,689,272 is also used for the hydrophilic treatment.

After the graining treatment and the anodizing treatment, a sealing anodized pore treatment is preferably applied to the aluminum plate. Such a sealing treatment is carried out by immersing the aluminum plate in hot water and an aqueous hot solution containing an inorganic salt or an organic salt or placing the aluminum plate in a steam bath.

If necessary, an organic underlayer is formed on the aluminum plate before forming a light-sensitive layer. An organic compound used for the organic underlayer is selected from carboxymethyl cellulose; dextrin; gum arabic; amino group-containing phosphonic acids such as 2-aminoethylphosphonic acid; organic phosphonic acids such as phenylphosphonic acid which may have a substituent, naphthylphosphonic acid which may have a substitutent, an alkylphosphonic acid which may have a substituent, glycerophopshonic acid which may have a substituent, methylenediphosphonic acid which may have a substituent, or ethylenediphosphonic acid which may have a substituent; organic phosphoric acids such as phenylphosphoric acid which may have a substituted, naphthylphosphoric acid which may have a substituent, an alkylphosphoric acid which may have a substituent, glycerophosphoric acid which may have a substituent, etc.; organic phosphinic acids such as phenylphosphinic acid which may have a substituent, naphthylphosphinic acid which may have a substituent, an alkylphosphinic acid which may have a substituent, or glycerophosphinic acid which may have a substituent; amino acids such as glycine, or β-alanine; the hydrochlorides of an amine having a hydroxyl group, such as the hydrochloride of triethanolamine; and sulfonic acids. They may be used alone or as mixtures thereof.

The organic underlayer can be formed by the following methods: a method of forming the organic underlayer by coating a solution obtained by dissolving the organic compound in water, an organic solvent such as methanol, ethanol, or methyl ethyl ketone, or a mixed solvent thereof on the aluminum plate followed by drying, and a method of forming the organic underlayer by immersing the aluminum plate in a solution obtained by dissolving the organic compound in water, an organic solvent such as methanol, ethanol, or methyl ethyl ketone, or a mixed solvent thereof to adsorb the organic compound on the aluminum plate, and then washing with water, etc., and drying. In the former method, the solution of the organic compound at a concentration of from 0.005 to 10% by weight can be coated by various methods. For example, a bar coater coating method, a rotation coating method, a spray coating method, a curtain coating method, etc., may be used. Also, in the latter method, the concentration of the solution is from 0.01 to 20% by weight, and preferably from 0.05 to 5% by weight, the immersing temperature is from 20 to 90°C, and preferably from 25 to 50°C, and the immersion time is from 0.1 second to 20 minutes, and preferably from 2 seconds to 1 minute.

The pH of the solution used is adjusted with a basic material such as ammonia, triethylamine, or potassium hydroxide, or an acidic material such as hydrochloric acid, or phosphoric acid, and the solution can be used at a pH in the range of from 1 to 12. Also, for improving the tone reproducibility of the light-sensitive lithographic printing plate, a yellow dye can be added to the solution.

The coverage of the organic underlayer after drying is suitably from 2 to 200 mg/m², and preferably from 5 to 100 mg/m². If the coverage is less than 2 mg/m², a sufficient printing resistance is not obtained. If the coverage is more than 200 mg/m², the printing resistance is also insufficient.

On the aluminum support thus treated is formed a layer of a positive-type light-sensitive composition (light-sensitive layer). The light-sensitive composition used in the present invention comprises an alkali-soluble and water-insoluble resin and a specific o-quinonediazide compound described below as a light-sensitive compound.

Further, polyhydroxyphenyl compounds suitable for white lamp safety described in JP-B-4-31104 are used. The polyhydroxyphenyl compounds include a condensation product of pyrogallol and acetone described in U.S. Patent 3,635,709; a polyester having a hydroxyl group at the terminal described in U.S. Patent 4,028,111; a homopolymer of p-hydroxystyrene or a copolymer of p-hydroxystyrene and other monomer capable of copolymerizing therewith as described in British Patent 1,494,043; a copolymer of p-aminostyrene and other monomer capable of copolymerizing therewith as described in U.S. Patent 3,759,711; and a phenol-formaldehyde resin or a cresol-formaldehyde resin as described in U.S. Patent 3,046,120. In particular, when the condensation product of pyrogallol and acetone is used, a light-sensitive composition excellent in the sensitivity and the development latitude is obtained.

In the present invention, 1,2-naphthoquinone-2-diazido-5-sulfonyl halide (A) and 1,2-naphthoquinone-2-diazido-4-sulfonyl halide (B) each being condensed with the polyhydroxyphenyl compound may be used alone or as a mixture thereof at a definite mixing ratio.

Other known o-naphthoquinonediazide compounds which can be used in the present invention are described in, for example, JP-A-47-5303, JP-A-48-63802, JP-A-48-63803, JP-A-48-96575, JP-A-49-38701, and JP-A-48-13354; JP-B-41-11222, JP-B-45-9610, and JP-B-49-17481; U.S. Patents 2,797,213, 3,454,400, 3,544,323, 3,573,917, 3,674,495, and 3,785,825; British Patents 1,227,602, 1,251,345, 1,267,005, 1,329,888, and 1,330,932; and German Patent 854,890.

The amount of the light-sensitive compound (o-quinonediazide) in the light-sensitive composition in the present invention is from 10 to 80% by weight, preferably from 15 to 50% by weight, and more preferably from 20 to 35% by weight.

The o-naphthoquinonediazide compound used as the light-sensitive compound in the present invention may in theory form a light-sensitive layer by itself but is used together with an alkali water-soluble and water-insoluble resin as a binder.

Such an alkali water-soluble resin is novolac resins having the above property. Examples of the resin are a phenol-formaldehyde resin and cresol-formaldehyde resins such as a m-cresol-formaldehyde resin, a p-cresol-formaldehyde resin, an o-cresol-formaldehyde resin, a m-/p-mixed cresol-formaldehyde resin, or phenol/cresol (m-, p-, o-, m-/p-, or m-/p-mixed cresol) mixture-formaldehyde resins.

Furthermore, resol type phenol resins are suitably used, phenol/cresol (m-, p-, o-, m-/p-. or m-/o-mixed cresol) mixture-formaldehyde resins are preferred, and the phenol resins described in JP-A-61-217034 are particularly preferred.

Various alkali-soluble high molecular weight compounds such as a phenol-modified xylene resin, polyhydroxystyrene, polyhydroxystyrene halide, the acrylic resin having a phenolic hydroxy group as disclosed in JP-A-51-34711, the acrylic resin having a sulfonamide group described in JP-A-2-866, or urethane resins, can be used. These alkali-soluble high molecular weight compounds having weight average molecular weights of from 500 to 100,000 and number average molecular weight of from 200 to 60,000 are preferred.

These alkali-soluble high molecular weight compounds may be used alone or as a combination thereof, and are used in an amount of 80% by weight or less, preferably from 30 to 75% by weight, and more preferably from 50 to 65% by weight, based on the weight of the whole composition. The use of the alkali-soluble high molecular weight compound in the range described above is preferable in the points of the developing property and the printing property.

Furthermore, as described in U.S. Patent 4,123,279, it is preferred for improving the sensitivity of the images to use the alkali-soluble high molecular weight compound together with the condensation product of a phenol having an alkyl group of from 3 to 8 carbon atoms as a substituent and formaldehyde, such as a t-butylphenol-formaldehyde resin, or an octylphenolformaldehyde resin.

A blue dye the tone of which is changed with an acid is added to the light-sensitive composition in the present invention as an image coloring agent.

The blue dye which can be used in the present invention is the basic dye comprising the salt of a cation having a basic dye skeleton and an organic anion of at least 10 carbon atoms, having a sulfonic acid group as an only exchange group and having from 1 to 3 hydroxyl groups.

The amount of the blue dye added is from 0.2 to 5% by weight, preferably from 0.25 to 4% by weight, and more preferably from 0.3 to 3% by weight, based on the weight of the whole light-sensitive composition. If the addition amount thereof is less than 0.2% by weight, the suitability for plate inspection after development is poor, while if the addition amount is more than 5% by weight, a bluish tone remains on the non-image areas after development.

As a coloring agent for images, other dyes can be also used in addition to the blue dyes described in JP-A-5-313359. The suitable dyes including salt-forming organic dyes are oil-soluble dyes and basic dyes. Specific examples thereof are Oil Green BG, Oil Blue BOS, and Oil Blue #603 (trade names, made by Orient Kagaku Kogyo K.K.), Victoria Pure Blue BOH, Victoria Pure Blue NAPS, and Ethyl violet 6HNAPS (trade names, made by Hodogaya Chemical Co., Ltd.), Rhodamine B (CI 45170B), Malachite Green (CI 42000), and Methylene Blue (CI 52015).

Further, a compound of generating an acid which changes the tone of the blue dye described in JP-A-5-313359 described above by interacting with the blue dye, namely, the o-naphthoquinonediazido-4-sulfonic acid halogenide described in JP-A-50-36209 (U.S. Patent 3,969,118), trihalomethyl-2-pyron and trihalomethyltriazine described in JP-A-53-36223 (U.S. Patent 4,160,671, or 2-trihalomethyl-5-aryl-1,3,4-oxadiazole compounds described in JP-A-55-77742 (U.S. Patent 4,279,982) is added to the light-sensitive composition in the present invention. In addition various o-naphthoquinonediazide compounds described in JP-A-55-62444 (U.S. Patent 2,038,801) may be present in the composition of the present invention.

In the present invention, the yellow dye reprsented by the formula [I], [II], or [III] described above and having the absorbance at 417 nm of at least 70% of the absorbance at 436 nm is added. These yellow dyes represented by the above formulae may be used as a combination of them. In addition, the absorbance was measured with a THF solvent at a concentration of about 5×10⁻⁶ M. If the absorbance is lower than 70%, the effect of inhibiting the formation of the unnecessary images of the edge portions of a film on the printing plate is small.

The yellow dyes represented by the formulae [I], [II], and [III] may be used alone or as a mixture thereof. The amount of the yellow dye(s) added is preferably from 0.01% to less than 10% based on the weight of the whole light-sensitive composition. If the amount thereof is less than 0.01%, the addition effect is not obtained and if the amount is 10% or more, the suitability for plate inspection is hard to see due to the increase of the yellowish tone. The more preferred amount of the yellow dye added is from 0.02% to less than 6%.

The yellow or orange coloring agent represented by the formula [I] described above used in the present invention is described in detail below.

In the formula [I], examples of the alkyl group represented by R₁, R₂, R₃, R₄, and R₅ preferably include an unsubstituted alkyl group having from 1 to 10 carbon atoms, such as methyl, or ethyl; a sulfonic acid group-containing alkyl group such as -CH₂CH₂CH₂SO₃H; a carboxyl group-substituted alkyl group such as carboxymethyl, or carboxyethyl; a sulfonamide-substituted alkyl group such as -CH₂SO₂NHCH₃, or -CH₂SO₂NHC₆H₅; an imide-substituted alkyl group such as -CH₂CONHCOCH₃, or -CH₂CONHCOC₆H₅; an N-sulfonylamide-substituted alkyl group such as -CH₂CH₂SO₂NHCOC₆H₄CH₃; an alkyl group having a phenolic hydroxyl group, such as -CH₂C₆H₄OH; a sufonimide group-containing alkyl group such as -CH₂C₆H₄-SO₂NHSO₂-C₆H₅; an alkyl group having a salt of a carboxyl group, such as a -COOH-NEt₃ salt, or a COOH diazabicycloundecene (DBU) salt; an alkyl group having a salt of sulfonamide, such as -SO₂N⁻PhNa⁺; an alkyl group having a salt of a phenolic hydroxyl group, such as -C₆H₄ONa; an alkyl group having a salt of N-sulfonylamide, such as -SO₂N⁻COC₆H₄CH₃Na⁺; and an imide group-having alkyl group, such as -CON⁻COCH₃DBUH⁺. Examples of other substituted alkyl group are alkyl groups each substituted by a non-phenolic hydroxyl group, a cyano group, an alkoxy group (e.g., methoxy, ethoxy, etc.), a halogen atom (e.g., Cl, Br, etc.), a carboalkoxy group, a sulfonyl group, an aryl group (e.g., phenyl, p-methoxyphenyl, etc.), a vinyl group, a methylvinyl group, or a cinnamyl group.

The aryl group represented by R₁ and R₂ is preferably a phenyl group and a naphthyl group. The aryl group may be substituted, and examples of the substituent are an alkyl group having from 1 to 10 carbon atoms, a hydroxyl group, a cyano group, an alkoxy group having from 1 to 10 carbon atoms (e.g., methoxy, ethoxy, etc.), a halogen atom (e.g., Cl, Br, etc.), a carboxyl group, a carboalkoxyl group, a sulfonyl group, an N-sulfonylamide group, a sulfonamide group, an imide group, a sulfonic acid group, and a sulfonimide group.

The alkenyl group represented by R₁ and R₂ is preferably, for example, a vinyl group. The alkenyl group may be substituted, and examples of the substituent are an alkyl group having from 1 to 10 carbon atoms, a sulfonic acid group, a carboxyl group, a sulfonamide group, an imide group, an N-sulfonylamide group, a phenolic hydroxyl group, a sulfonimide group or a metal salt thereof, an inorganic or organic ammonium salt, and an aryl group having from 6 to 18 carbon atoms. These substituents may be further substituted by a substituted or unsubstituted alkyl group having from 1 to 10 carbon atoms such as methyl, or ethyl, or a carboxyalkyl group.

R₁ and R₂ may form a ring such as a 5-membered ring, 6-membered ring, and a 5-membered ring or 6-membered ring each condensed with an aromatic ring. Also, these rings may have a substituent such as an alkyl group, an aryl group, a substituted alkyl group, a substituted aryl group, a hydroxyl group, a cyano group, an alkoxy group, a halogen atom, a sulfonic acid group, a carboxyl group, a sulfonamide group, an imide group, an N-sulfonylamide group, a phenolic hydroxyl group, a sulfonimide group or a metal salt thereof, an inorganic or organic ammonium salt, a carboalkoxy group, or a sulfonyl group.

G₁ and G₂ each represent an alkoxycarbonyl group, an aryloxycabonyl group, an acyl group, an arylcarbonyl group, an alkylthio group, an arylthio group, an alkylsulfonyl group, an arylsulfonyl group, or a fluoroalkylsulfonyl group.

The alkyl group in the above groups is preferably an alkyl group having from 1 to 10 carbon atoms, and the aryl group in the above groups is preferably a phenyl group and a naphthyl group. These alkyl group and aryl group may have a substituent such as an alkyl group having from 1 to 10 carbon atoms, a hydroxyl group, a cyano group, an alkoxy group having from 1 to 10 carbon atoms, a halogen atom, a carboxyl group, a carboalkoxy group, a sulfonyl group, a sulfoalkoxy group, an aryl group having from 6 to 18 carbon atoms, an acyl group, a vinyl group, or a cinnamyl group.

G₁ and G₂ may form a ring comprising non-metallic atoms together with carbon atoms to which they are bonded. The ring formed is a ring usually used as an acidic nucleus for a merocyanine dye, and examples thereof include the following nuclei.
(1) 1,3-Dicarbonyl nuclei such as 1,3-indandione, 1,3-cyclohexandione, 5,5-dimethyl-1,3-cyclohexandione, or 1,3-dioxane-4,6-dione.
(2) Pyrazolinone nuclei such as 3-methyl-2-pyrazolin-5-one, 1-phenyl-2-pyrazolin-5-one, or 1-(2-benzothiazline)-3-methyl-2-pyrazolin-one.
(3) Isoxazolinone nuclei such as 3-phenyl-2-isoxazolin-5-one, or 3-methyl-2-isoxazolin-5-one.
(4) Oxyindole nuclei such as a 1-alkyl-2,3-dihydro-2-oxyindole.
(5) 2,4,6-Triketohexahydropyrimidine nuclei such as barbituric acid, 2-thiobarbituric acid, and derivatives thereof. Examples of the derivatives are 1-alkyl substances such as 1-methyl, or 1-ethyl; 1,3-dialkyl substances such as 1,3-diethyl, or 1,3-dibutyl; 1,3-diaryl substances such as 1,3-diphenyl, 1,3-di(p-chlorophenyl), or 1,3-di(p-ethoxycarbonylphenyl); 1-alkyl-3-aryl substances such as 1-ethyl-3-phenyl; and those having a functional group at 1-position and/or 3-position, such as 1-allyl-3-carboxypentyl, 1,3-bis(carboxypentyl), 1-carboxypropyl-3-phenyl, 1-carboxypropyl-3-(4-hydroxyphenyl), 1-carboxyphenyl-3-phenyl, 1,3-bis(carboxyphenyl), 1-allyl-3-{2-(N-phenylsulfamoyl)ethyl}, 1-ethyl-3-{2-(N-benzoylsulfamoyl)ethyl}, 1,3-bis(hydroxyphenyl), or 1-allyl-3-{2-(benzenesulfonylaminosulfonyl)ethyl}.
(6) 2-Thio-2,4-thiazolidinedione nuclei such as rhodanine and the derivatives thereof. Examples of the derivatives are 3-alkylrhodanines such as 3-ethylrhodanine, or 3-allylrhodanine; arylrhodanines such as 3-phenylrhodanine; 3-carboxyalkylrhodanines such as 3-carboxymethylrhodanine, or 3-carboxyethylrhodanine; and 3-carboxyarylrhodanines such as 3-carboxyphenylrhodanine.
(7) 2-Thio-2,4-oxazolidinedione(2-thio-2,4-(3H,5H)-oxazoledione) nuclei such as 2-ethyl-2-thio-2,4-oxazolidinedione.
(8) Thianaphthenone nuclei such as 3(2H)-thianaphthenone, or 3(2H)-thianaphthenone-1,1-dioxide.
(9) 2-Thio-2,5-thiazolidinedione nuclei such as 3-ethyl-2-thio-2,5-thiazolidinedione.
(10) 2,4-Thiazolidinedione nuclei such as 2,4-thiazolidinedione, 3-ethyl-2,4-thiazolidinedione, or 3-phenyl-2,4-thiazolidonedione.
(11) Thiazolidinone nuclei such as 4-thiazolidinone, or 3-ethyl-4-thiazolidine.
(12) 4-Thiazolinone nuclei such as 2-ethylmercapto-5-thiazolin-4-one, or 2-alkylphenylamino-5-thiazolin-4-one.
(13) 2-Imino-2-oxozolin-4-one (pseudohydantoin) nuclei.
(14) 2,4-Imidazilidinedione (hydantoin) nuclei such as 2,4-imidazolidinedione, or 3-ethyl-2,4-imidazolidinedione.
(15) 2-Thio-2,4-imidazolidindione (2-thiohydantoin) nuclei such as 2-thio-2,4-imidazolidindione, or 3-ethyl-2-thio-2,4-imidazolidindione.
(16) 2-Imidazolin-5-one nuclei such as 2-n-propylmercapto-2-imidazolin-5-one.
(17) Furan-5-one.
(18) 4-Hydroxy-2(1H)-quinoline nuclei or 4-hydroxy-2(1H)-pyridinone nuclei, such as N-methyl-4-hydroxy-2(1H)-quinoline, N-n-butyl-4-hydroxy-2(1H)-quinoline, or N-methyl-4-hydroxy-2(1H)-pyridinone.
(19) Substituted or unsubstituted 4-hydroxy-2H-pyran-2-one and 4-hydroxycoumarin.
(20) Substituted or unsubstituted thioindoxyl such as 5-methylthioindoxyl.

In the formula [I], n₁ represents 0 or 1.

Y represents a divalent atom or atomic group selected from O, S, NR (wherein R represents a hydrogen atom or substituted or unsubstituted alkyl group having from 1 to 20, and preferably from 1 to 10, carbon atoms, or an aryl group), Se, -C(CH₂)₂-, and -CH=CH-.

The yellow or orange coloring agent represented by the formula [I] used in the present invention is preferably the compound represented by following formula [IV]; 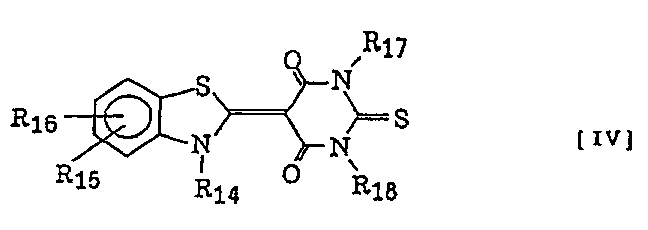 wherein R₁₄, R₁₅, R₁₆, R₁₇, and R₁₈ each independently represent a hydrogen atom, a halogen atom, an alkyl group, an aryl group, or an allyl group (these groups each may have a substituent).

However, at least one of R₁₄, R₁₅, R₁₆, R₁₇, and R₁₈ has at least one of a sulfonic acid group, a carboxyl group, a sulfonamide group, an imide group, an N-sulfonylamide group, a phenolic hydroxyl group, a sulfonimide group or the metal salt thereof, and an inorganic or organic ammonium salt. In these substituting positions, R₁₄, R₁₇, and R₁₈ are preferred, and examples of the substituent are preferably the sulfonic acid group, the carboxyl group, the sulfonamide group or the metal salt thereof, and the inorganic or organic ammonium salt. R₁₅ and R₁₆ may form a ring together with the carbon atoms to which they are bonded.

More specifically, R₁₄, R₁₅, R₁₆, R₁₇, and R₁₈ each independently represent a hydrogen atom, a halogen atom (e.g., fluorine, chlorine and bromine), an alkyl group having from 1 to 12 carbon atoms, such as methyl, ethyl, n-propyl, i-propyl, n-butyl, or t-butyl; an aryl group having from 6 to 10 carbon atoms, such as phenyl, or naphthyl; or an allyl group having from 3 to 10 carbon atoms.

These alkyl group, aryl group and allyl group each may have a substituent, and examples of the substituent are an alkyl group having from 1 to 6 carbon atoms, such as methyl, or ethyl; an alkoxy group having from 1 to 6 carbon atoms, such as methoxy, or ethoxy; a halogen atom such as chlorine, or bromine; a cyano group; an amino group; an amino group substituted with an alkyl group having from 1 Lo 4 carbon atoms, such as dimethylamino; a carboalkoxy group having an alkyl group of from 1 to 4 carbon atoms, such as carbomethoxy; a substituted or unsubstituted aryl group having from 6 to 10 carbon atoms, such as phenyl, p-methoxyphenyl, or p-chlorophenyl; a sulfonic acid group-containing alkyl or aryl group such as -CH₂CH₂CH₂SO₃H; a COOH group-substituted alkyl or aryl group such as -CH₂COOH, or carboxyethyl; a sulfonamide group-substituted alkyl or aryl group such as -SO₂NHCH₃, or -SO₂NHC₆H₅; an imide group-substituted alkyl or aryl group such as -CONHCOCH₃, or -CONHCOC₆H₅; an N-sulfonylamide group-substituted alkyl or aryl group such as -SO₂NHC₆H₄CH₃; a phenolic hydroxyl group-having alkyl or aryl group such as -C₆H₄OH; a sulfonimide group-having alkyl or aryl group such as -C₆H₄-SO₂NHSO₂-C₆H₅; an alkyl or aryl group having a salt of a carboxyl group, such as a -COOH-NEt₃ salt, or a COOH diazabicycloundecene (DBU) salt; an alkyl or aryl group having the salt of a sulfonamide group, such as -SO₂N⁻Ph⁺Na; an alkyl or aryl group having a salt of a phenolic hydroxyl group, such as -C₆H₄ONa; an alkyl or aryl group having a salt of an N-sulfonylamide group, such as -SO₂N⁻COC₆H₄CH₃Na⁺; and an alkyl or aryl group having a salt of an imide group, such as CON⁻COCH₃DBUH⁺.

R₁₅ and R₁₆ may form a ring together with the carbon atoms to which they are bonded. Examples of the ring are an aliphatic hydrocarbon ring such as a cyclohexene ring; an aromatic ring such as a benzene ring, or a naphthalene ring; and a heteroaromatic ring such as a quinoline ring. Also, these rings each may have a substituent, and examples of the substituent which can be used are the same substituents as the substituents of R₁₄, R₁₅, R₁₆, R₁₇, and R₁₈.

The compounds represented by the formula [I] or [IV] described above, which can be used in the present invention, can be synthesized using conventional methods. Typical synthetic methods are described in, e.g., T.H. James, The Theory of Photographic Process, 4th edition, published by Macmillan Co., New York, 1977; F.M. Hamer, The Cyanine Dyes and Related Compounds, published by John Wiley & Sons Co., New York, 1964; and JP-A-61-203443.

Specific examples of these compounds are shown below.

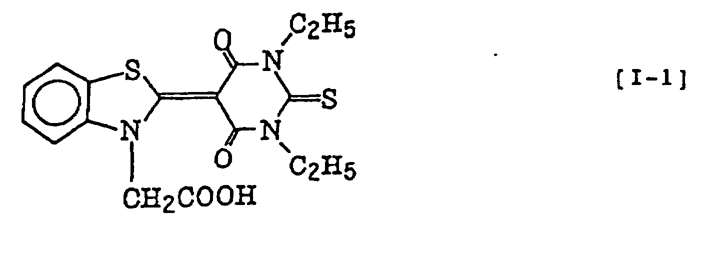

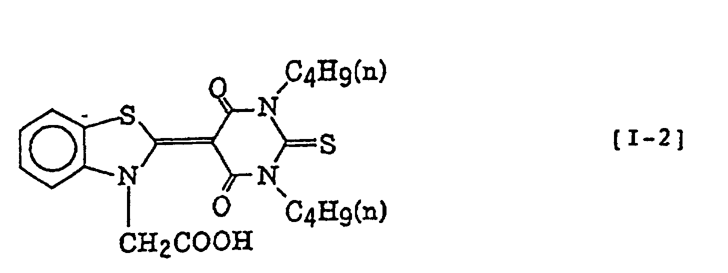

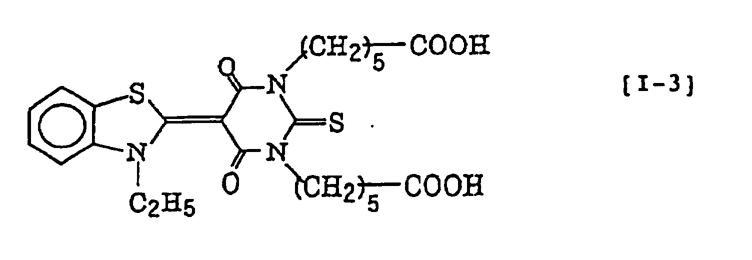

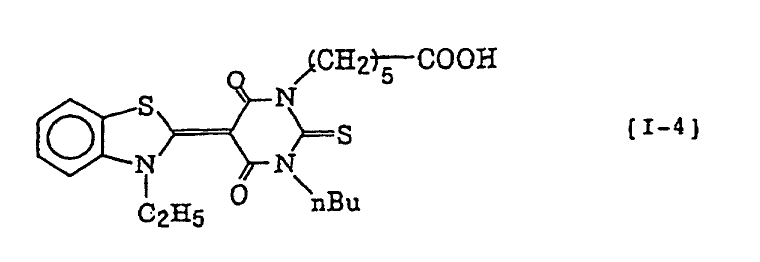

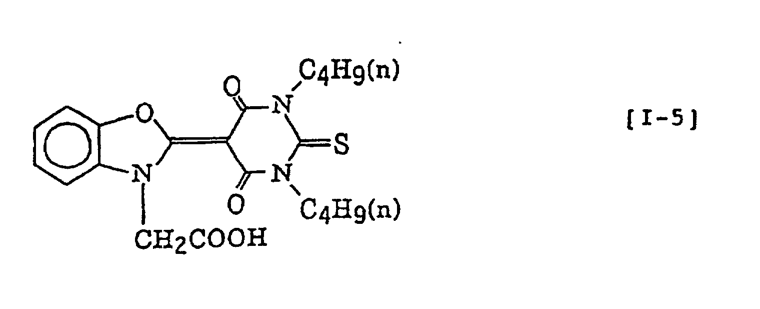

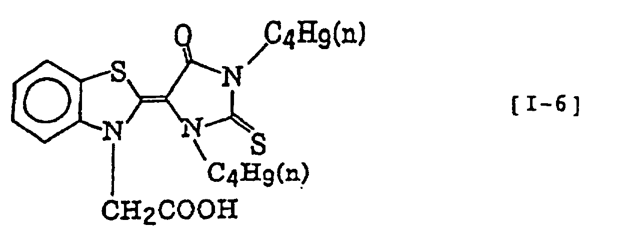

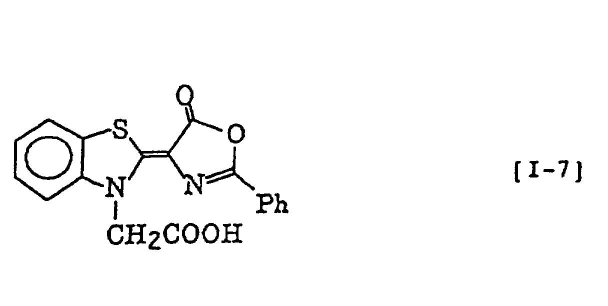

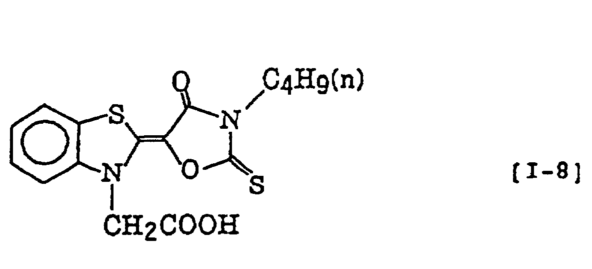

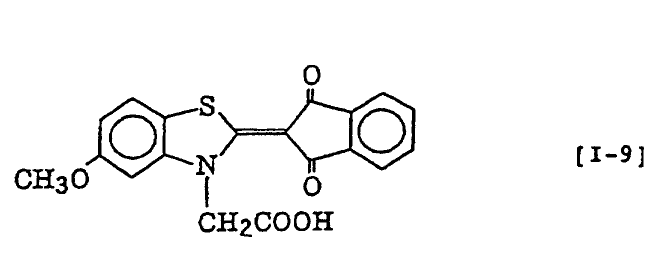

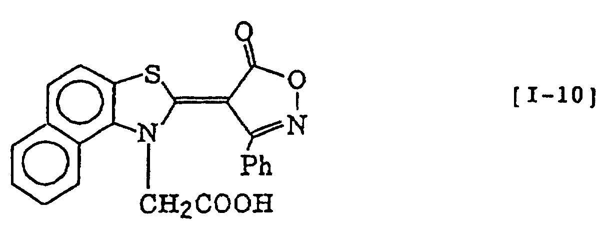

The yellow or orange coloring agent represented by the formula [II] described above, which can be used in the present invention, is described in detail below.

In the formula [II], R₆ and R₇ each independently represent a hydrogen atom, an alkyl group, a substituted alkyl group, an aryl group, a substituted aryl group, a heterocyclic group, a substituted heterocyclic group, an allyl group, or a substituted allyl group. R₆ and R₇ may form a ring together with the carbon atoms to which they are bonded.

n₂ represents 0, 1, or 2.

G₃ and G₄, which may be the same or different, each represent a hydrogen atom, a cyano group, an alkoxycarbonyl group, a substituted alkoxycarbonyl group, an aryloxycarbonyl group, a substituted aryloxycarbonyl group, an acyl group, a substituted acyl group, an arylcarbonyl group, a substituted aryloxycarbonyl group, an alkylthio group, an arylthio group, an alkylsulfonyl group, an arylsulfonyl group, or a fluoroalkylsulfonyl group, with the proviso that G₃ and G₄ are not simultaneously a hydrogen atom. G₃ and G₄ may form a ring comprising non-metallic atoms together with the carbon atoms to which they are bonded.

At least one of R₆, R₇, G₃, and G₄ has at least one of a sulfonic acid group, a carboxyl group, a sulfonamide group, an imide group, an N-sulfonylamide group, a phenolic hydroxyl group, a sulfonimide group or the metal salt thereof, and an inorganic or organic ammonium salt.

The formula [II] is explained in more detail below.

The alkyl group represented by R₆ and R₇ is preferably an alkyl group having from 1 to 10 carbon atoms, such as methyl, ethyl, or t-butyl. The substituted alkyl group includes the above alkyl group of from 1 to 10 carbon atoms having a substituent such as a hydroxyl group, a cyano group, an alkoxy group (e.g., methoxy, ethoxy, etc.), a halogen atom (e.g., Cl, Br, etc.), a carboxyl group, or a sulfonyl group.

The aryl group represented by R₆ and R₇ is preferably phenyl and naphthyl. The substituted aryl group includes a phenyl or naphthyl group having a substituent such as an alkyl group having from 1 to 10 carbon atoms, a hydroxyl group, a cyano group, an alkoxy group (e.g., methoxy, ethoxy, etc.), a halogen atom (e.g., Cl, Br, etc.), a carboxyl group, or a sulfonyl group.

The heterocyclic group represented by R₆ and R₇ is preferably thienyl, benzothienyl, furyl, and benzofuryl. The substituted heterocyclic group includes the above heterocyclic group having a substituent such as a halogen atom (e.g., Cl, Br, etc.), or an alkyl group (e.g., methyl, ethyl, etc.). Examples of the substituent of the substituted allyl group represented by R₆ and R₇ are an alkyl group such as methyl, or ethyl, and a halogen atom (e.g., Cl, Br, etc.).

R₆ and R₇ may form a ring together with the carbon atoms to which they are bonded as described above, and specific examples of the ring are a substituted or unsubstituted aromatic ring such as benzene, naphthalene, or anthracene, and a substituted or unsubstituted heterocyclic ring such as furan, thiophene, imidazole, pyrrole, oxazole, pyrazole, pyrazoline, triazole, tetrazole, furazane, thiazole, pyran, pyridine, pyrazine, triazine, tetrazine, oxazine, benzofuran, benzothiophene, indole, indoline, benzimidazole, benzoxazole, benzothiazole, carbazole, or dibenzofuran.

G₃ and G₄ have the same meaning as G₁ and G₂ of the formula [I] described above, respectively.

G₃ and G₄ may form a ring comprising non-metallic atoms together with the carbon atoms to which they are bonded as described above. The ring is a ring usually used as an acidic nucleus of a merocyanine dye, and examples of the ring are rings (1) to (17) shown above as the rings in forming a ring by G₁ and G₂ of the formula [I].

Specific examples of the compound represented by the formula [II] are shown below.

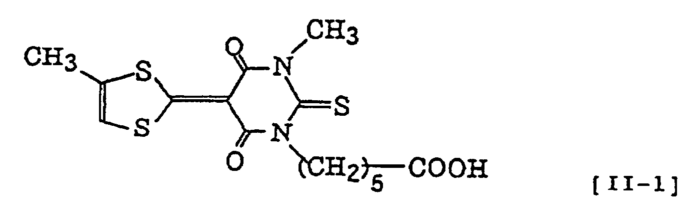

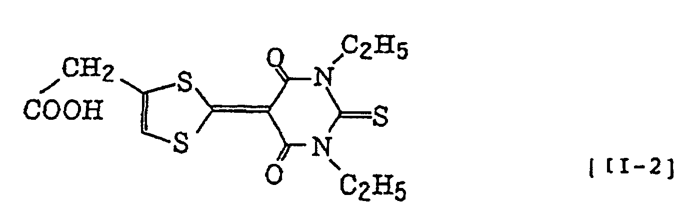

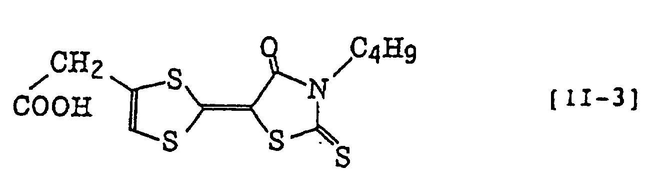

The yellow or orange coloring agent represented by the formula [III] described above, which can be used in the present invention, is explained below.

In the formula [III], R₈, R₉, R₁₀, R₁₁, R₁₂, and R₁₃ each independently represent a hydrogen atom, an alkyl group having from 1 to 6 carbon atoms, a substituted alkyl group, an aryl group having from 6 to 10 carbon atoms, a substituted aryl group, an alkoxy group having from 1 to 6 carbon atoms, an alkoxycarbonyl group having from 1 to 6 carbon atoms, a hydroxyl group, an acyl group, a cyano group, an aryloxycarbonyl group having from 6 to 10 carbon atoms, a nitro group, a carboxyl group, a chloro group, or a bromo group.

Specific examples of the compound represented by the formula [III] are shown below.

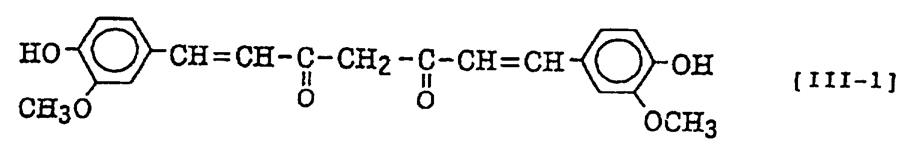

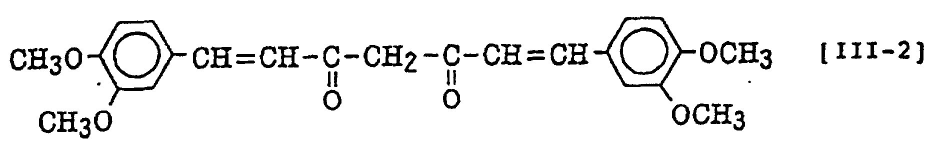

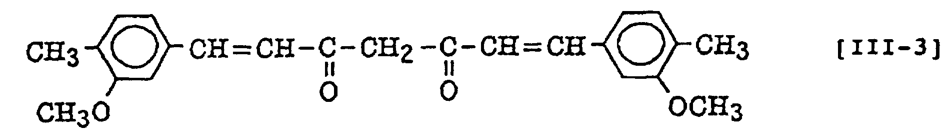

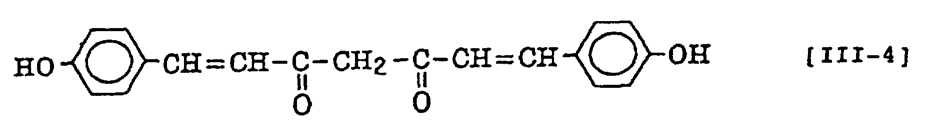

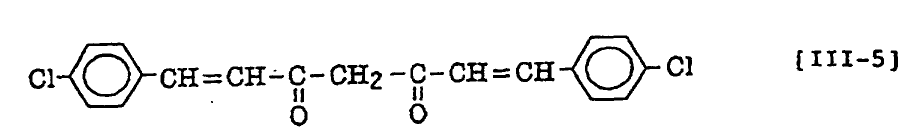

It is preferred to add cyclic acid anhydrides, phenols, or organic acids to the light-sensitive composition in the present invention in order to increase the sensitivity.

Examples of the cyclic acid anhydrides are phthalic anhydride, tetrahydrophthalic anhydride, hexahydrophthalic anhydride, 3,6-endoxy-Δ⁴-tetrahydrophthalic anhydride, tetrachlorophthalic anhydride, maleic anhydride, chloromaleic anhydride, α-phenylmaleic anhydride, succinic anhydride, and pyromellitic anhydride, as described in U.S. Patent 4,115,128.

Examples of the phenols are bisphenol A, p-nitrophenol, p-ethoxyphenol, 2,3,4-trihydroxybenzophenone, 4-hydroxybenzophenone, 2,4,4'-trihydroxybenzophenone, 4,4,4"-trihydroxytriphenylmethane, and 4,4',3",4"-tetrahydroxy-3,5-3',5'-tetramethyltriphenylmethane.

Examples of the organic acids are sulfonic acids, sulfinic acids, alkylsulfuric acids, phosphonic acids, phosphinic acids, phosphoric acid esters, and carboxylic acids, described in JP-A-60-88942, and JP-A-2-96755. Specific examples thereof are p-toluenesulfonic acid, dodecylbenzenesulfonic acid, p-toluenesulfinic acid, ethylsulfuric acid, phenylphophonic acid, phenylphosphinic acid, phenyl phosphate, diphenyl phosphate, benzoic acid, isophthalic acid, adipic acid, p-toluic acid, 3,4-dimethoxybenzoic acid, phthalic acid, terephthalic acid, 1,4-cyclohexene-2,2-dicarboxylic acid, ericic acid, lauric acid, n-undecanic acid, and ascorbic acid.

The proportion of the above cyclic acid anhydrides, phenols or organic acids in the light-sensitive composition in the present invention is preferably from 0.05 to 15% by weight, and more preferably from 0.1 to 5% by weight.

The light-sensitive composition in the present invention can contain a nonionic surface active agent as described in JP-A-62-251740 and JP-A-4-68355 or an amphoteric surface active agent as described in JP-A-59-121044 and JP-A-4-13149.

Examples of the nonionic surface active agent are sorbitan tristearate, sorbitan monopalmitate, sorbitan trioleate, stearic acid monoglyceride, polyoxyethylene sorbitan monooleate, and polyoxyethylene nonylphenyl ether.

Examples of the amphoteric surface active agent are an alkyldi(aminoethyl)glycine, an alkylpolyaminoethylglycine hydrochloride, Amorgen K (trade name, made by DAI-ICHI KOGYO SEIYAKU CO., LTD., N-tetradecyl-N,N-betaine type), a 2-alkyl-N-carboxyethyl-N-hydrocyethylimidazoloniumbetaine, and Rebon 15 (trade name, made by SANYO CHEMICAL INDUSTRIES, LTD., alkylimidazoline type).

The proportion of the nonionic surface active agent or amphoteric surface active agent in the light-sensitive composition is preferably from 0.05 to 15% by weight, and more preferably from 0.1 to 5% by weight.

The light-sensitive lithographic printing plate of the present invention is obtained by dissolving the components of the light-sensitive composition in a solvent and coating the resulting solution on a support.

Examples of the solvent which can be used are γ-butyrolactone, ethylene dichloride, cyclohexanone, methyl ethyl ketone, ethylene glycol monomethyl ether, ethylene glycol monoethyl ether, 2-methoxyethyl acetate, 1-methoxy-2-propanol, 1-methoxy-2-propyl acetate, toluene, ethyl acetate, methyl lactate, ethyl lactate, dimethyl sulfoxide, dimethylacetamide, dimethylformamide, water, N-methylpyrrolidone, tetrahydrofurfuryl alcohol, acetone, diacetone alcohol, methanol, ethanol, isopropanol, and diethylene glycol dimethyl ether. These solvents may be used alone or as a mixture thereof. The concentration (solid content) of the components in the solution is from 2 to 50% by weight.

The coating amount is preferably from 0.5 g/m² to 2.5 g/m² in dry thickness. If the coating amount is less than 0.5 g/m², the printing resistance is deteriorated and if the coating amount is more than 2.5 g/m², the tone reproducing property is deteriorated.

The light-sensitive layer in the present invention can contain the fluorine surface active agent as described in, for example, JP-A-62-170950 as a surface active agent for improving the coating property. The addition amount thereof is preferably from 0.01 to 1% by weight, and more preferably from 0.05 to 0.5% by weight, based on the weight of the whole light-sensitive composition.

It is preferred that the surface of the light-sensitive layer formed as described above is subjected to a matting treatment in order to shorten an evacuating time at a contact exposure using a vacuum printing frame and also prevent occurrence of a printing blur. Specifically, there are a method of forming a matted layer as described in JP-A-50-125805, JP-B-57-6582, and JP-B-61-28986, and a method of heat-welding a solid powder onto the surface of the light-sensitive layer as described in JP-B-62-62337.

The developer for the light-sensitive lithographic printing plate of the present invention is preferably an alkaline aqueous solution which does not substantially contain an organic solvent. Examples thereof are aqueous solutions of sodium silicate, potassium silicate, sodium hydroxide, potassium hydroxide, lithium hydroxide, sodium tertiary phosphate, sodium secondary phosphate, ammonium tertiary phosphate, ammonium secondary phosphate, sodium metasilicate, sodium carbonate, sodium hydrogencarbonate, potassium carbonate, and potassium hydrogencarbonate, and an aqueous ammonia. The concentration of the solution is from 0.1 to 10% by weight, and preferably from 0.5 to 5% by weight.

Of these developers, the developer containing an alkali silicate such as potassium silicate, lithium silicate, or .sodium silicate is preferred since staining at printing is hard to form. The developer having the composition of the alkali silicate being [SiO₂]/[M] = 0.5 to 2.5 by molar ratio (wherein [SiO₂] and [M] show the mol concentration of SiO₂ and the mol concentration of the total alkali metals, respectively) and containing SiO₂ in an amount of from 0.8 to 8% by weight is preferably used.

The developer can contain a water-soluble sulfite such as sodium sulfite, potassium sulfite, or magnesium sulfite; resorcin; methylresorcin; hydroquinone; or thiosalicylic acid. The content of the compound in the developer is from 0.002 to 4% by weight, and preferably from 0.01 to 1% by weight.

By incorporating at least one of the anionic surface active agent and the amphoteric surface active agent as described in JP-A-50-51324 and JP-A-59-84241 and the nonionic surface active agent as described in JP-A-59-75255, JP-A-60-111245, and JP-A-60-213943 in the developer, or by incorporating a high molecular weight electrolyte as described in JP-A-55-95946 and JP-A-56-142528 in the developer, a wetting property to the light-sensitive composition can be increased and the stability of development (development latitude) can be increased. Such a developer is preferably used.

The amount of the surface active agent added is preferably from 0.001 to 2% by weight, and more preferably from 0.003 to 0.5% by weight. Further, it is preferred that the developer contains potassium as the alkali metal of the alkali silicate in an amount of at least 20 mol% per mole of the total alkali metals for forming less insoluble matters in the developer. The content of potassium is more preferably at least 90 mol% and most preferably 100 mol%.

The developer used in the present invention can further contain a small amount of an organic solvent such as an alcohol, a chelating agent described in JP-A-58-190952, and a defoaming agent such as the metal salt and an organic silane compound as described in JP-B-1-30139.

The light source used for the light exposure includes a carbon arc lamp, a mercury lamp, a xenon lamp, a tungsten lamp, and a metal halide lamp.

The light-sensitive lithographic printing plate of the present invention may be, as a matter of course, subjected to a plate-making treatment by methods described in JP-A-54-8002, JP-A-55-115045, and JP-A-59-58431.

That is, after development, the developed printing plate may be subjected to a desensitization treatment after water washing, or as it is, or may be subjected to a treatment with an aqueous solution containing an acid, or further may be subjected to a desensitization treatment after being treated with an aqueous solution containing an acid.

Further, in the development process of the light-sensitive lithographic plates of this kind, the processing capacity is lowered since the aqueous alkali solution is consumed according to the processing amount to reduce the alkali concentration or the alkali concentration with air by a long time operation of an automatic development. In such a case, however, the processing capacity may be recovered using the replenisher as described in JP-A-54-62004. In this case, it is preferred to replenish by the method described in U.S. Patent 4,882,246. Also, it is preferred that the plate making treatment is carried out by the automatic developing apparatus as described in JP-A-2-7054 and JP-A-2-32357. In the case of erasing unnecessary image portions after image-exposing the light-sensitive lithographic printing plate of the present invention, developing, and water washing or rinsing the printing plate, it is preferred to use an erasing liquid as described in JP-A-2-13293.

An insensitizing gum which is coated, if desired, in the final process of the plate-making process is preferably materials described in JP-B-62-16834, JP-B-62-25118, JP-B-63-52600, JP-A-62-7595, JP-A-62-11693, and JP-A-62-93194.

Furthermore, when the light-sensitive lithographic printing plate of the present invention is image-exposed, developed, washed with water or rinsed, if necessary, subjected to an erasing work, and after water-washing, subjected to burning, it is preferred to treat the surface of the printing plate with a plate buring conditioner as described in JP-B-61-2518, JP-B-55-28062, JP-A-62-31859, and JP-A-61-159655.

The present invention is described in more detail by the following examples. Unless otherwise indicated, "%" in the examples is "% by weight".

### Examples 1 to 8 and Comparative Examples 1 to 8

After graining a surface of a 0.30 mm thick aluminum plate using a nylon brush and an aqueous suspension of pumice of 400 mesh, the aluminum plate was washed well with water. After etching the aluminum plate by immersing it in a 10% sodium hydroxide aqueous solution at 70°C for 60 seconds, the plate was washed with running water, washed for neutralization with a 20% HNO₃ aqueous solution, and washed with water. The aluminum plate was then subjected to an electrolytic graining treatment in a 1% nitric acid aqueous solution using a sine wave alternating electric current under the condition of VA = 12.7 volts at the quantity of anodic electricity of 260 coulombs/dm². When the surface roughness was measured, the surface roughness was 0.55 µm (Rₐ). The aluminum plate was further immersed in a 30% H₂SO₄ aqueous solution and after desmatting for 2 minutes, the aluminum plate was anodized in a 20% H₂SO₄ aqueous solution at a current density of 2 A/dm² such that the coverage of the oxide film formed became 1.6 g/m₂ to obtain a base plate.

The surface of the base plate thus treated was coated with an undercoat liquid (A) having the following composition and dried at 80°C for 30 seconds.

The coated amount after drying was 10 mg/m².

| Undercoat Liquid (A): | |
|---|---|
| β-Alanine | 0.05 g |
| Hydrochloride of triethanolamine | 0.05 g |
| Methanol | 40 g |
| Pure water | 50 g |

Thus, a base plate (I) was prepared.

On the base plate (I), the following light-sensitive liquid was coated at 25 ml/m² by rod coating and dried at 100°C for one minute to obtain a positive-type light-sensitive lithographic printing plate. The coated amount of the light-sensitive liquid after drying was about 1.0 g/m².

| Light-Sensitive Liquid: | |
|---|---|
| Esterified product of 1,2-diazonaphthoquinone-5-sulfonyl chloride and a pyrogallol-acetone resin (described in Example 1 of U.S. Patent 3,635,709) | 0.90 g |
| Cresol-formaldehyde novolac resin (meta/para ratio: 6/4, weight average molecular weight: 3,000, number average molecular weight 1,000, containing 0.7% unreacted cresol) | 1.60 g |
| m-Cresol-formaldehyde novolac resin (weight average molecular weight 1,700, number average molecular weight 600, containing 1% unreacted cresol) | 0.3 g |
| Poly[N-(p-aminosulfonylphenyl)acrylamido-co-normalbutyl acrylate-co-diethylene glycol monomethyl ether methacrylate] (molar ratio of the monomers is 40:40:20, weight average molecular weight 40,000, number average molecular weight 20,000) | 0.2 g |
| p-n-Octylphenol-formaldehyde resin (described in U.S.Patent 4,123,279) | 0.02 g |
| Naphthoquinonediazido-1,2-diazido-4-sulfonic acid chloride | 0.01 g |
| Yellow dye | Table A |
| Tetrahydrophthalic anhydride | 0.02 g |
| Benzoic acid | 0.02 g |
| Compound described in JP-A-63-58440: | 0.02 g |
| N-(1,2-naphthoquinone-2-diazido-4-sulfonyloxy)-cyclohexane-1,2-dicarboxylic acid imide | 0.01 g |
| Blue dye obtained by changing the counter anion of Victoria Pure Blue (made by HODOGAYA CHEMICAL CO., LTD.) to 1-naphthalenesulfonic acid | 0.05 g |
| Megafack F-176 (made by DAINIPPON INK AND CHEMICALS, INC., fluorine surface active agent) | 0.01 g |
| Methyl ethyl ketone | 55 g |

A matted layer was formed on the plate thus coated by electrostatically spraying an aqueous solution of a copolymer of methyl methacrylate/ethyl acrylate/sodium acrylate = 68/20/12 having dissolved therein tartrazine in an amount of 0.1 g to 100 g of the copolymer aqueous solution based on the method described in Example 1 of JP-B-61-28986.

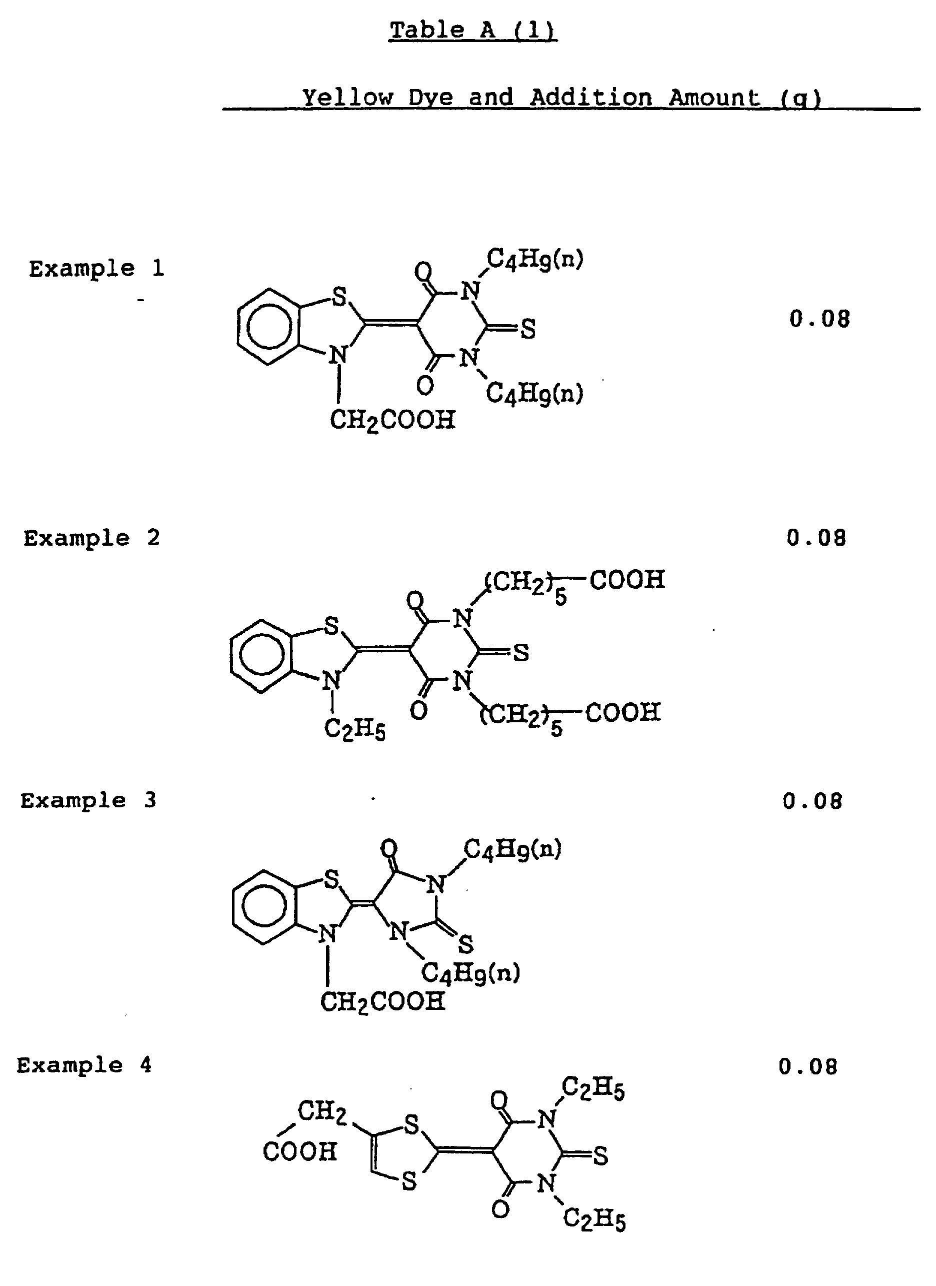

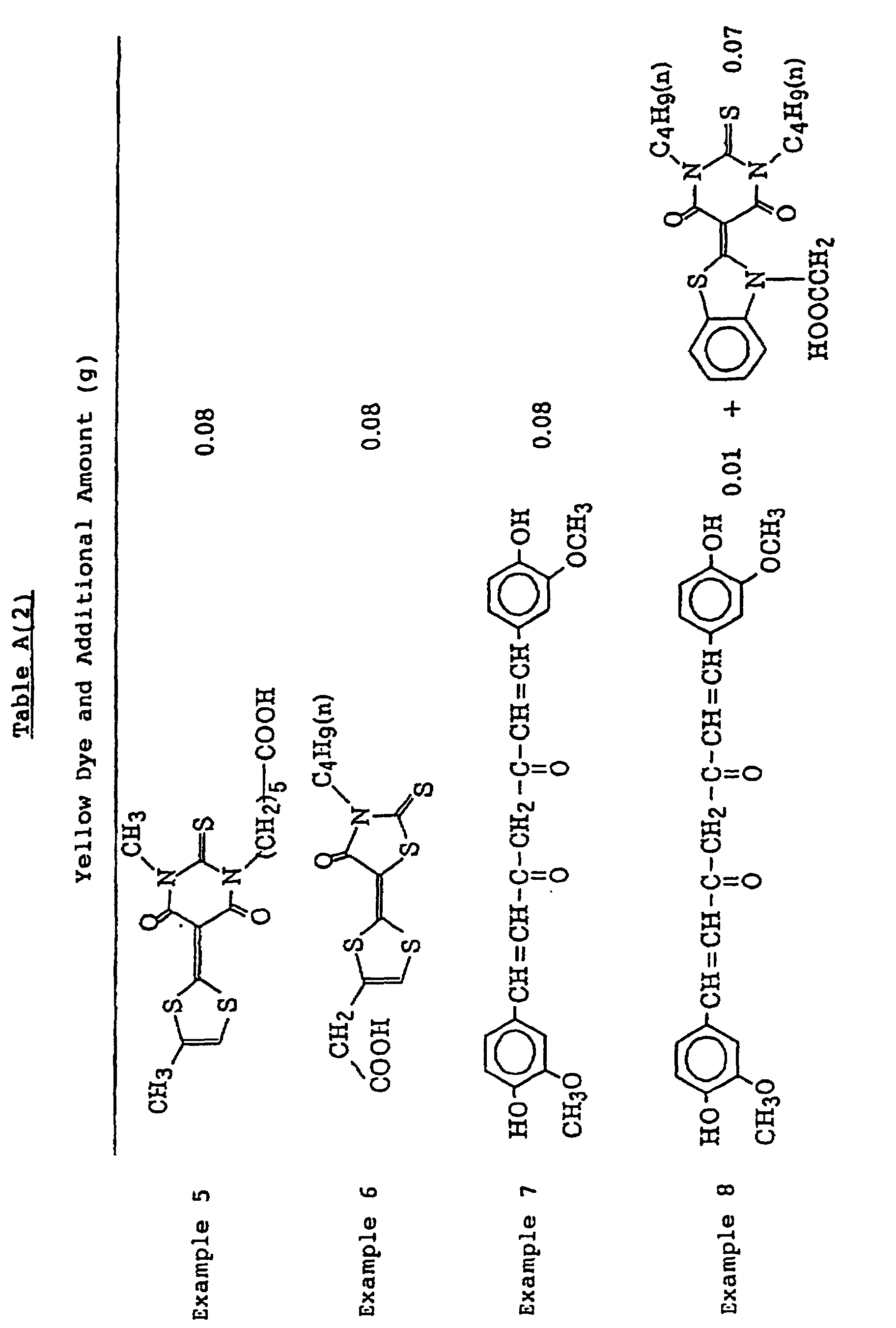

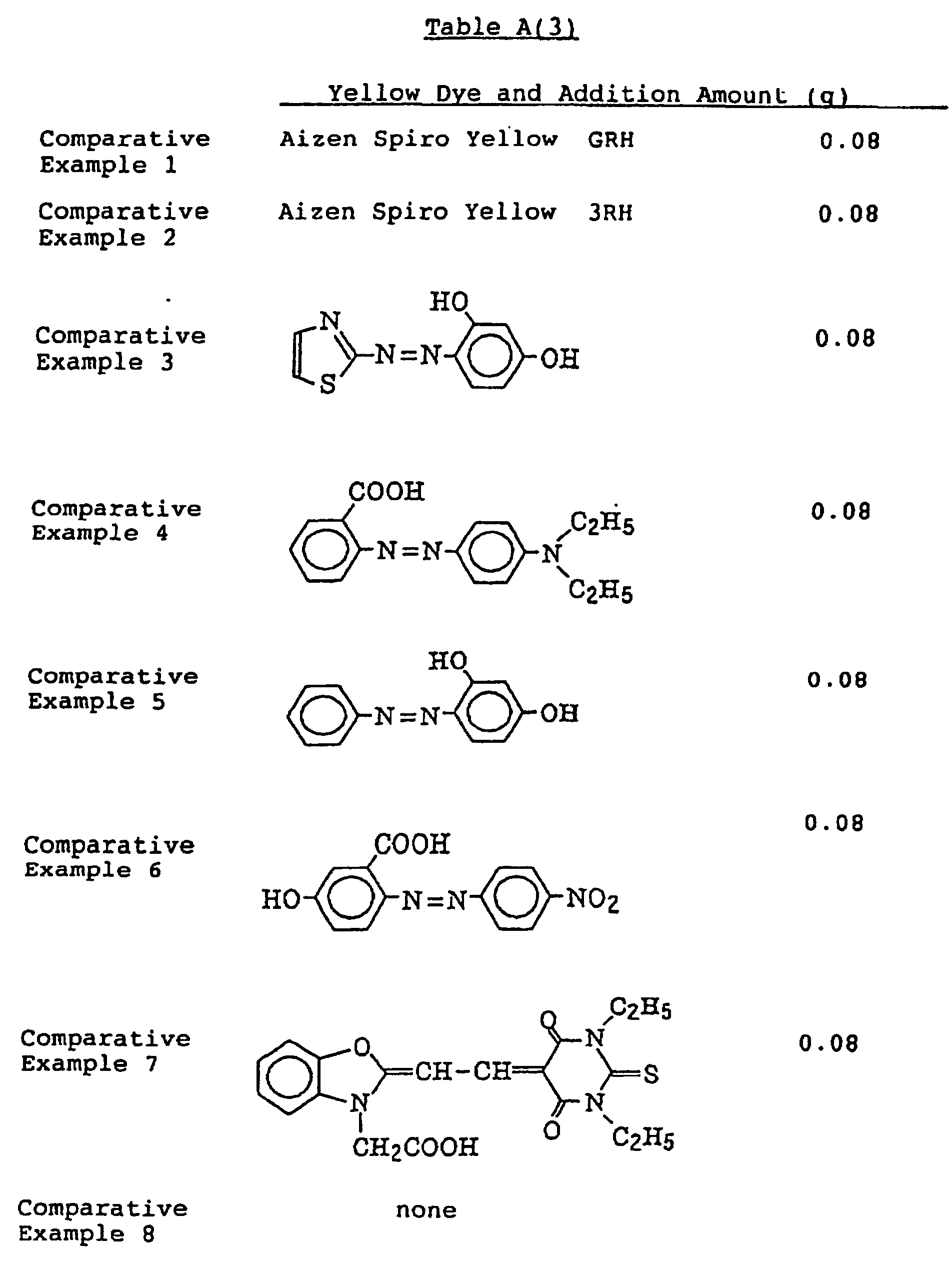

Using a 2KW metal halide lamp (Idolfin 2000, trade name, manufactured by IWASAKI ELECTRIC CO., LTD.) as the light source, the exposure time was controlled for each of the light-sensitive lithographic plates such that after irradiating with light having an energy of 8.0 mW/cm² and development, 10 µm was reproduced at the Fogra PMSK value. After exposure, the visible image property of the printing plate was visually evaluated, and the exposed printing plate was processed through an automatic processor, Stablon 900D (trade name, manufactured by Fuji Photo Film Co., Ltd.) containing a 5.26% sodium silicate aqueous solution (pH = 12.7) having SiO₂/Na₂O of 1.74 by molar ratio as a developer and FP-2W (1:1) (made by Fuji Photo Film Co., Ltd.) as a finisher.

The easiness of seeing the images and the presence or absence of the unnecessary images of the edge portions of a film were examined on the printing plates thus obtained.

The results obtained are shown in Table B below.

**Table B**

| | (A) | (B) | (C) | (D) | (E) |
|---|---|---|---|---|---|
| Example 1 | good | good | good | 45 sec. | none |
| " 2 | " | " | " | 40 sec. | " |
| " 3 | " | " | " | 50 sec. | " |
| " 4 | " | " | " | 50 sec. | " |
| " 5 | " | " | " | 55 sec. | " |
| " 6 | " | " | " | 50 sec. | " |
| " 7 | " | " | " | 40 sec. | " |
| " 8 | " | " | " | 40 sec. | " |
| Comparative Example 1 | good | good | good | 100 sec. | none |
| " 2 | " | " | " | 100 sec. | " |
| " 3 | bad | " | " | 55 sec. | " |
| " 4 | " | " | " | 50 sec. | " |
| " 5 | " | " | " | 50 sec. | " |
| " 6 | " | " | " | 60 sec. | |
| " 7 | " | " | " | 60 sec. | found |
| " 8 | good | bad | bad | 40 sec. | found |
| (A): Image-seeing property after light exposure. | | | | | |
| (B): Easiness of seeing register marks. | | | | | |
| (C): Suitability for plate inspection after development | | | | | |
| (D): Exposure time required for reproducing 10 µm. | | | | | |
| (E): Presence or absence of the unnecessary images of the edge portions of film. | | | | | |

As shown in Table B above, it can be seen that the samples of Examples 1 to 8 meet all the properties.

The present invention can provide a positive-type light-sensitive lithographic printing plate wherein the unnecessary images of the edge portions of a film are difficult to form on the plate, and the image-seeing property after light exposure and the suitability for plate inspection after development are good, register marks are easy to see, and which has a high sensitivity.

## Claims

1. A positive-type light-sensitive lithographic printing plate comprising an aluminium plate, which was grained and then subjected to an anodizing treatment, having formed on the surface thereof a layer of a light-sensitive composition containing following components a) to e):
a) an o-naphthoquinonediazide compound selected from 1,2 naphthoquinone-2-diazido-5-sulfonoyl halide and 1,2-naphthoquinone-2-diazido-4-sulfonyl halide, each being condensed with a polyhydroxyphenyl compound,
b) an alkaline water-soluble and water-insoluble resin,
c) a compound which generates an acid by light, selected from o-naphthoquinonediazido-4-sulfonic acid halogenide, trihalomethyl-2-pyrone, trihalomethyltriazine and 2-trihalomethyl-5-aryl-1,3,4-oxadiazole,
d) a blue dye the tone of which is changed with an acid, and
e) a yellow dye represented by the following formula [I], [II] or [III], the absorbance at 417 nm of which is at least 70% of the absorbance of 436 nm. 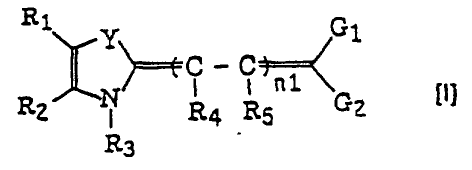
wherein R₁ and R₂ each independently represent a hydrogen atom, an alkyl group having from 1 to 10 carbon atoms, an aryl group, or an alkenyl group, and R₁ and R₂ may form a ring; R₃, R₄ and R₅ each independently represent a hydrogen atom or an alkyl group having from 1 to 10 carbon atoms; G1 and G2 each independently represent an alkoxycarbonyl group, an aryloxycarbonyl group, an acyl group, an arylcarbonyl group, an alkylthio group, an arylthio group, an alkylsulfonyl group, an arylsulfonyl group, or a fluoroalkylsulfonyl group, and G₁ and G₂ may form a ring; at least one of R₁, R₂, R₃, R₄, R₅, G₁, and G₂ has at least one of a sulfonic acid group, a carboxyl group, a sulfonamide group, an imido group, an N-sulfonylamide group, a phenoliç hydroxyl group, a sulfonamide group, and the metal salts, the inorganic and organic ammonium salts of them; Y represents a divalent atom or atomic group selected from O, S, NR (wherein R represents a hydrogen atom, an alkyl group, or an aryl group), Se, -C(CH₃)₂-, and -CH=CH-; and n₁ represents 0 or 1. 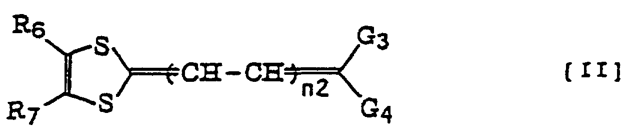 wherein R₆ and R₇ each independently represent a hydrogen atom, an alkyl group, a substituted alkyl group, an aryl group, a substituted aryl group, a heterocyclic group, a substituted heterocyclic group, an allyl group, or a substituted allyl group, and R₆ and R₇ may form a ring together with the carbon atoms to which R₆ and R₇ are bonded, respectively; n₂ represents 0, 1, or 2; G₃ and G₄, which may be the same or different, each represent a hydrogen atom, a cyano group, an alkoxycarbonyl group, a substituted alkoxycarbonyl group, an aryloxycarbonyl group, a substituted aryloxycarbonyl group, an acyl group, a substituted acyl group, an arylcarbonyl group, a substituted arylcarbonyl group, an alkylthio group, an arylthio group, an alkylsulfonyl group, an arylsulfonyl group, or a fluoroalkylsulfonyl group; with the proviso that G₃ and G₄ are not simultaneously a hydrogen atom, and also G₃ and G₄ may form a ring composed of non-metallic atoms together with the carbon atoms to which G₃ and G₄ are bonded, respectively; and at least one of R₆, R₇, G₃, and G₄ has at least one of a sulfonic acid group, a carboxyl group, a sulfonamide group, an imido group, an N-sulfonylamide group, a phenolic hydroxyl group, a sulfonamide group, and the metal salts, the inorganic and organic ammonium salts of them; 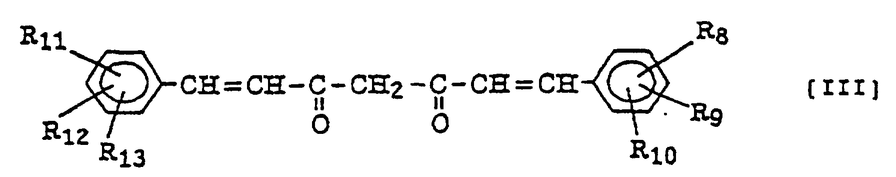 wherein R₈, R₉, R₁₀, R₁₁, R₁₂, and R₁₃, which may be the same or different, each represent a hydrogen atom, an alkyl group, a substituted alkyl group, an aryl group, a substituted aryl group, an alkoxy group, a hydroxyl group, an acyl group, a cyano group, an alkoxycarbonyl group, an aryloxycarbonyl group, a nitro group, a carboxyl group, a chloro group, or a bromo group.

2. The positive light-sensitive lithographic printing plate as claimed in claim 1, wherein component c) is trihalomethyltriazine.

## Patentansprüche

1. Positiv arbeitende lichtempfindliche lithografische Druckplatte, umfassend eine Aluminiumplatte, die aufgeraut wurde und dann einer Anodisierungsbehandlung unterworfen wurde, auf der Oberfläche davon geformt eine Schicht einer lichtempfindlichen Zusammensetzung, enthaltend die folgenden Komponenten a) bis e):
a) eine o-Naphthochinondiazidverbindung, ausgewählt unter 1,2 Naphthochinon-2-diazido-5-sulfonoylhalogenid und 1,2-Naphthochinon-2-diazido-4-sulfonylhalogenid, jeweils kondensiert mit einer Polyhydroxyphenylverbindung,
b) ein in alkalischem Wasser lösliches und in Wasser unlösliches Harz,
c) eine Verbindung, die eine Säure durch Licht erzeugt, ausgewählt unter o-Naphthochinondiazido-4-sulfonsäurehalogenid, Trihalomethyl-2-pyron, Trihalomethyltriazin und 2-Trihalomethyl-5-aryl-1,3,4-oxadiazol,
d) einen blauen Farbstoff, dessen Farbton mit einer Säure verändert wird, und
e) einen gelben Farbstoff, dargestellt durch die folgenden Formeln [I], [II] oder [III], dessen Absorption bei 417 nm mindestens 70 % der Absorption bei 436 nm beträgt. 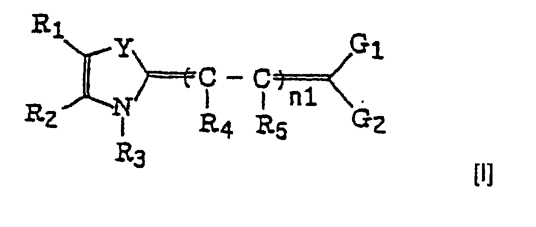
worin R₁ und R₂ jeweils unabhängig ein Wasserstoffatom, eine Alkylgruppe mit 1 bis 10 Kohlenstoffatomen, eine Arylgruppe oder eine Alkenylgruppe darstellen, und R₁ und R₂ einen Ring formen können; R₃, R₄ und R₅ jeweils unabhängig ein Wasserstoffatom oder eine Alkylgruppe mit von 1 bis 10 Kohlenstoffatomen darstellen; G₁ und G₂ jeweils unabhängig voneinander eine Alkoxycarbonylgruppe, eine Aryloxycarbonylgruppe, eine Acylgruppe, eine Arylcarbonylgruppe, eine Alkylthiogruppe, eine Arylthiogruppe, eine Alkylsulfonylgruppe, eine Arylsulfonylgruppe oder eine Fluoroalkylsulfonylgruppe darstellen, und G₁ und G₂ einen Ring formen können; mindestens einer unter R₁, R₂, R₃, R₄, R₅, G₁ und G₂ mindestens eine Sulfonsäuregruppe, eine Carboxylgruppe, eine Sulfonamidgruppe, eine Imidogruppe, eine N-Sulfonylamidgruppe, eine phenolische Hydroxylgruppe, eine Sulfonamidgruppe und das Metallsalz, das anorganische oder organische Ammoniumsalz davon aufweist; Y ein divalentes Atom oder eine divalente Atomgruppe darstellt, ausgewählt unter O, S, NR (wobei R ein Wasserstoffatom, eine Alkylgruppe oder eine Arylgruppe darstellt), Se, -C(CH₃)₂- und -CH=CH-; und n₁ 0 oder 1 darstellt. 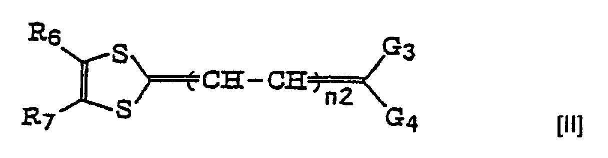 worin R₆ und R₇ jeweils unabhängig ein Wasserstoffatom, eine Alkylgruppe, eine substituierte Alkylgruppe, eine Arylgruppe, eine substituierte Arylgruppe, eine heterocyclische Gruppe, eine substituierte heterocyclische Gruppe, eine Allylgruppe oder eine substituierte Allylgruppe darstellen, und R₆ und R₇ einen Ring formen können, zusammen mit den Kohlenstoffatomen, an welche R₆ und R₇ gebunden sind; n₂ 0, 1 oder 2 darstellt; G₃ und G₄, die gleich oder verschieden sein können, jeweils ein Wasserstoffatom, eine Cyanogruppe, eine Alkoxycarbonylgruppe, eine substituierte Alkoxycarbonylgruppe, eine Aryloxycarbonylgruppe, eine substituierte Aryloxycarbonylgruppe, eine Acylgruppe, eine substituierte Acylgruppe, eine Arylcarbonylgruppe, eine substituierte Arylcarbonylgruppe, eine Alkylthiogruppe, eine Arylthiogruppe, eine Alkylsulfonylgruppe, eine Arylsulfonylgruppe oder eine Fluoroalkylsulfonylgruppe, darstellen; mit der Maßgabe, dass G₃ und G₄ nicht gleichzeitig ein Wasserstoffatom sind, und wobei auch G₃ und G₄ einen Ring formen können, zusammengesetzt aus nichtmetallischen Atomen, zusammen mit den Kohlenstoffatomen, an welche G₃ und G₄ gebunden sind; und wobei mindestens einer unter R₆, R₇, G₃ und G₄ mindestens eine Sulfonsäuregruppe, eine Carboxylgruppe, eine Sulfonamidgruppe, eine Imidogruppe, eine N-Sulfonylamidgruppe, eine phenolische Hydroxylgruppe, eine Sulfonamidgruppe und die Metallsalze, die anorganischen und organischen Ammoniumsalze davon aufweist; 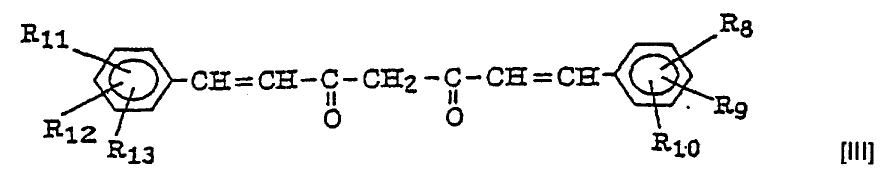 worin R₈, R₉, R₁₀, R₁₁, R₁₂ und R₁₃, die gleich oder verschieden sein können, jeweils ein Wasserstoffatom, eine Alkylgruppe, eine substituierte Alkylgruppe, eine Arylgruppe, eine substituierte Arylgruppe, eine Alkoxygruppe, eine Hydroxylgruppe, eine Acylgruppe, eine Cyanogruppe, eine Alkoxycarbonylgruppe, eine Aryloxycarbonylgruppe, eine Nitrogruppe, eine Carboxylgruppe, eine Chlorogruppe oder eine Bromogruppe darstellen.

2. Positiv arbeitende lichtempfindliche lithografische Druckplatte nach Anspruch 1, wobei Komponente c) Trihalomethyltriazin ist.

## Revendications

1. Planche d'impression lithographique photosensible de type positif comprenant une plaque d'aluminium, qu'on a grainée et soumise ensuite à une anodisation, ayant formé sur la surface de celle-ci une couche d'une composition photosensible contenant les composants a) à e) suivants :
a) un composé de type diazoture de o-naphtoquinone sélectionné parmi un halogénure de 1,2-naphtoquinone-2-diazido-5-sulfonoyle et un halogénure de 1,2-naphtoquinone-2-diazido-4-sulfonoyle, chacun étant condensé avec un composé de type polyhydroxyphényle,
b) une résine soluble dans l'eau alcaline et insoluble dans l'eau,
c) un composé qui génère un acide par la lumière, sélectionné parmi un halogénure d'acide o-naphtoquinonediazido-4-sulfonique, une trihalométhyl-2-pyrone, une trihalométhyltriazine et un 2-trihalométhyl-5-aryl-1,3,4-oxadipyrrole,
d) un colorant bleu dont le ton est changé avec un acide, et
e) un colorant jaune représenté par les formules [I], [II] ou [III] suivantes, dont l'absorbance à 417 nm est d'au moins 70% de l'absorbance à 436 nm. 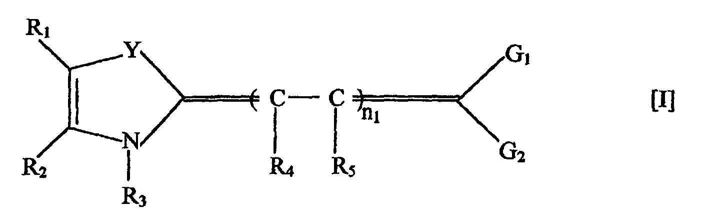
dans laquelle R₁ et R₂ d'une façon indépendante l'un de l'autre représentent chacun un atome d'hydrogène, un groupe alkyle ayant entre 1 et 10 atomes de carbone, un groupe aryle ou un groupe alcényle, et R₁ et R₂ peuvent former un cycle; R₃, R₄ et R₅ d'une façon indépendante les uns des autres représentent chacun un atome d'hydrogène ou un groupe alkyle ayant entre 1 et 10 atomes de carbone ; G₁ et G₂ d'une façon indépendante l'un de l'autre représentent chacun un groupe alcoxycarbonyle, un groupe aryloxycarbonyle, un groupe acyle, un groupe arylcarbonyle, un groupe alkylthio, un groupe arylthio, un groupe alkylsulfonyle, un groupe arylsulfonyle ou un groupe fluoroalkylsulfonyle, et G₁ et G₂ peuvent former un cycle; au moins un des substituants R₁, R₂, R₃, R₄, R₅, G₁ et G₂ a au moins un groupe parmi un groupe acide sulfonique, un groupe carboxyle, un groupe sulfonamide, un groupe imido, un groupe N-sulfonylamide, un groupe hydroxyle phénolique, un groupe sulfonamide et les sels métalliques, les sels d'ammonium inorganiques et organiques de ceux-ci ; Y représente un atome divalent ou un groupe atomique sélectionné parmi O, S, NR (dans lequel R représente un atome d'hydrogène, un groupe alkyle ou un groupe aryle), Se, -C(CH₃)₂- et -CH=CH- ; et n₁ représente 0 ou1. 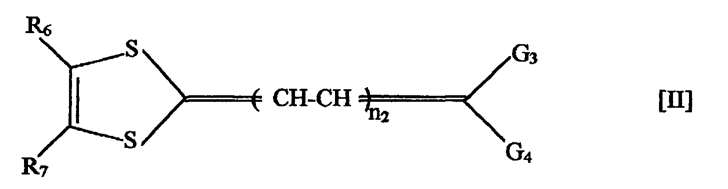 dans laquelle R₆ et R₇ d'une façon indépendante l'un de l'autre représentent chacun un atome d'hydrogène, un groupe alkyle, un groupe alkyle substitué, un groupe aryle, un groupe aryle substitué, un groupe hétérocyclique, un groupe hétérocyclique substitué, un groupe allyle ou un groupe allyle substitué, et R₆ et R₇ peuvent former un cycle en association avec les atomes de carbone auxquels R₆ et R₇ sont liés, respectivement ; n₂ représente 0, 1 ou 2 ; G₃ et G₄, qui peuvent être identiques ou différents, représentent chacun un atome d'hydrogène, un groupe cyano, un groupe alcoxycarbonyle, un groupe alcoxycarbonyle substitué, un groupe aryloxycarbonyle, un groupe aryloxycarbonyle substitué, un groupe acyle, un groupe acyle substitué, un groupe arylcarbonyle, un groupe arylcarbonyle substitué, un groupe alkylthio, un groupe arylthio, un groupe alkylsulfonyle, un groupe arylsulfonyle ou un groupe fluoroalkylsulfonyle ; à condition que G₃ et G₄ ne soient pas en même temps un atome d'hydrogène, et G₃ et G₄ aussi peuvent former un cycle composé d'atomes non métalliques en association avec les atomes de carbone auxquels G₃ et G₄ sont liés, respectivement ; et au moins un des substituants R₆, R₇, G₃ et G₄ a au moins un groupe parmi un groupe acide sulfonique, un groupe carboxyle, un groupe sulfonamide, un groupe imido, un groupe N-sulfonylamide, un groupe hydroxyle phénolique, un groupe sulfonamide et les sels métalliques, les sels d'ammonium inorganiques et organiques de ceux-ci ; 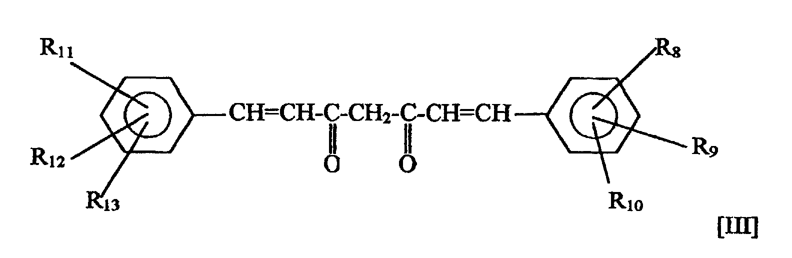 dans laquelle R₈, R₉, R₁₀, R₁₁, R₁₂ et R₁₃, qui peuvent être identiques ou différents, représentent chacun un atome d'hydrogène, un groupe alkyle, un groupe alkyle substitué, un groupe aryle, un groupe aryle substitué, un groupe alcoxy, un groupe hydroxyle, un groupe acyle, un groupe cyano, un groupe alcoxycarbonyle, un groupe aryloxycarbonyle, un groupe nitro, un groupe carboxyle, un groupe chloro ou un groupe bromo.

2. Planche d'impression lithographique photosensible positive selon la revendication 1, dans laquelle le composant c) est une trihalométhyltriazine.
